# EUROPEAN PATENT SPECIFICATION

(11) **EP 4 236 643 B1**
(45) Date of publication and mention of the grant of the patent: **20.08.2025**
(21) Application number: 22175963.2
(22) Date of filing: 28.05.2022
(51) Int. Cl.: H05K 7/20

(54) **RUGGEDIZING APPARATUS AND METHOD FOR ELECTRONIC EQUIPMENT MOUNTED ON SPACECRAFT**
VORRICHTUNG UND VERFAHREN ZUR ÜBERWACHUNG VON IN RAUMFAHRZEUGEN MONTIERTEN ELEKTRONISCHEN GERÄTEN
APPAREIL DE RENFORCEMENT ET PROCÉDÉ POUR ÉQUIPEMENT ÉLECTRONIQUE MONTÉ SUR UN ENGIN SPATIAL

(30) Priority: 25.02.2022 JP 2022028322
(43) Date of publication of application: 30.08.2023
(60) Divisional application: 23188594.8
(73) Proprietor: NEC Corporation, 108-8001 Tokyo (JP)
(72) Inventor: MOCHIDA, Norihiko, Tokyo, 108-8001 (JP)
(74) Representative: Betten & Resch

(56) References cited:
- EP-A1- 3 232 753
- US-A1- 2016 257 433
- US-B2- 11 172 593

## Description

The present application relates to ruggedizing techniques for electronic equipment mounted on a spacecraft such as a space vehicle or the like.

Spacecrafts operating in the space environment are constantly bombarded with a very high dose of cosmic rays from all directions. In particular, collisions of high-energy particles such as protons and heavy particles with semiconductor circuits in the spacecraft induce a phenomenon known as the single-event effect or total dose effect, which may cause control system failures. Neutrons may be generated by nuclear reactions between high-energy particles and metal parts inside the electronic equipment, which may also cause malfunctions. To protect the electronic equipment from cosmic rays, various ruggedizing techniques have been proposed. Usually, consumer-oriented electronic components are not designed for use in harsh environments. Accordingly, ruggedizing techniques are indispensable in the case where the electronic equipment is used in harsh space environments.

As an example of a ruggedizing technique, JP2002-166899 (hereinafter, referred to as Patent document 1) discloses a space-environment ruggedizing container for protecting consumer electronic components from cosmic rays. This space-environment ruggedizing container is made of aluminum 3 millimeters in thickness, aiming to reduce weight and reliably shield cosmic rays (mainly electrons and protons).

On the other hand, many electronic components include semiconductor circuits (e.g., processors) that generate heat during operation. In the case where such heat-generating electronic components are sealed within a container, it is necessary to provide a means of dissipating heat to outside. The above-mentioned Patent document 1 discloses a structure in which a cooling plate is provided on the bottom plate of a container to conduct heat generated by electronic components to the outside for heat exhaustion.

There have been proposed a lot of heat dissipating mechanisms. For instance, JP H07-025395 (hereinafter, referred to as Patent document 2) discloses a heat dissipation device that improves heat dissipation efficiency. More specifically, a heat pipe mounted on the heat-generating part of an onboard device of a satellite is joined to a heat pipe of the heat dissipation part outside the heat-generating part.

In recent years, immersion cooling, in which the electronic device itself is immersed in a coolant bath, has attracted attention as a method for cooling electronic devices such as computers. For example, in JP Patent No. 6720752 (hereinafter, referred to as Patent document 3), an electronic device is immersed in a coolant bath filled with a first coolant. In addition, a liquid cooling jacket is provided to cool the electronic device by flowing a second coolant from the outside into the liquid cooling jacket. A liquid flow generator is provided in the coolant bath to flow the first coolant in the coolant bath for enhanced cooling efficiency. U.S. Patent No. 9750159B2 (hereinafter, referred to as Patent document 4) also discloses a liquid immersion cooling device that flows a coolant by means of a pump, and describes an example of efficiently dissipating heat from electronic components by convection and boiling of the coolant.

### List of Related-art documents:

[Patent document 1] JP2002-166899;
[Patent document 2] JP H07-025395;
[Patent document 3] JP Patent No. 6720752; and
[Patent document 4] U.S. Patent No. 9750159B2.
US 2016/257433 A discloses the preamble of claim 1.

However, the space-environment ruggedizing container as disclosed in Patent document 1 encloses heat-generating integrated circuits with a metal wall. The material and thickness of the metal wall are designed for shielding mainly against electrons and protons. Accordingly, the space-environment ruggedizing container designed as such cannot be shielded efficiently against other particles such as neutrons. In addition, according to the heat dissipation methods disclosed in Patent documents 1 and 2, it is difficult to achieve high dissipation efficiency of heat because the heat from integrated circuits is dissipated by means of thermal conduction through multiple components.

The immersion cooling devices described in Patent documents 3 and 4 employ a cooling system designed for normal use in gravity environment on the ground. Accordingly, they have no means of preventing the electronic devices from cosmic rays. Furthermore, they are not designed for use in zero-gravity space environment.

As described above, to stably operate electronic equipment in space environments, it is necessary to shield the electronic equipment against cosmic rays. On the other hand, such shielding makes heat dissipation difficult. Such trade-off between shielding and heat dissipation must be solved.

In immersion cooling, different coolant flowing means are required: a means of flowing a first coolant in which the electronic equipment is immersed; and another means of flowing a second coolant for cooling that first coolant, which results in complicated structure and increased weight. Accordingly, such an immersion cooling device cannot be mounted on a spacecraft as it is. In particular, the convection of the coolant does not occur in weightless space, in which bubbles due to boiling are prevented from removing from heat dissipation fins, causing dry-out phenomenon.

An object of the present invention is to provide ruggedizing apparatus and method for electronic equipment mounted on a spacecraft, achieving both a radiation shielding effect to reduce the effects of space rays from the space environment and a heat-dissipation effect to dissipate the heat generated by electronic equipment.

The above object is achieved with the features of the independent claims.

According to the present invention, the heat-generating electronic circuits are immersed in the coolant of the pressure vessel, and the coolant is forced to flow on the electronic circuits, thereby achieving both radiation shielding and immersion cooling effects.

Fig. 1 illustrates a schematic cross-sectional view of a ruggedizing apparatus according to an exemplary embodiment of the present invention.
Fig. 2 illustrates a schematic side view partially broken away of an example of a forced-liquid flow generator in the ruggedizing apparatus according to the exemplary embodiment.
Fig. 3 illustrates a schematic plan view of the forced-liquid flow generator in the ruggedizing apparatus according to the exemplary embodiment.
Fig. 4 illustrates a schematic diagram of a man-made satellite to which an example of the ruggedizing apparatus according to the exemplary embodiment is applied.

### <Outline of an exemplary embodiment>

According to an exemplary embodiment of the present invention, an immersion cooling system is employed for cooling electronic equipment in a spacecraft. More specifically, the spacecraft electronic equipment or at least heat-generating parts of the electronic equipment is immersed in a coolant and placed in a pressure vessel filled with the coolant. Accordingly, at least the space around the electronic circuitry is filled with the coolant, which provides a radiation moderation effect.

According to the exemplary embodiment, a forced liquid-flow generator is provided in the pressure vessel. The forced liquid-flow generator forces the coolant on electronic circuits to flow, preventing the dry-out phenomenon even in a space where gravity is negligible. The forced coolant flow efficiently cools the electronic circuits and dissipates its heat to the outside through the wall of the pressure vessel. In other words, by employing the immersion cooling system and forcedly flowing the coolant, both radiation shielding and immersion cooling effects can be achieved.

Exemplary embodiments of the present invention will be described in detail below with reference to the drawings. It should be noted that the components, their shapes, dimensions and dimension ratios, and arrangements described in the following embodiments are just examples for explaining the embodiments and are not intended to limit the technical scope of the invention to them.

### 1. Exemplary embodiment

### 1.1) Structure

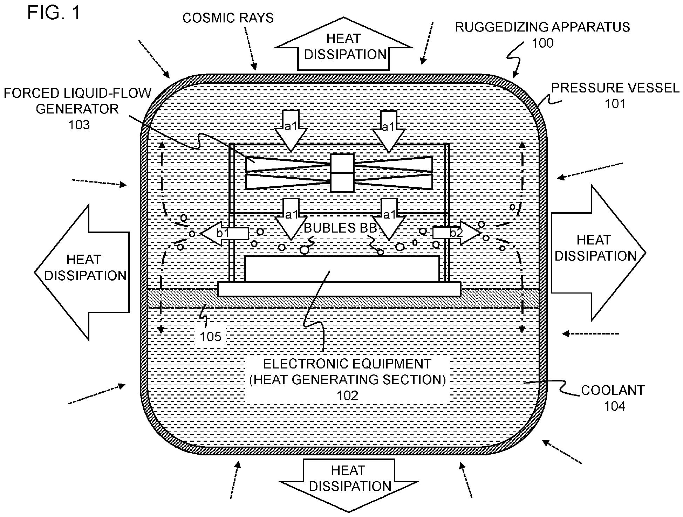

As illustrated in Fig. 1, a ruggedizing apparatus 100 according to an exemplary embodiment of the present invention includes a pressure vessel 101 in which electronic equipment 102 as a heat source and a forced liquid-flow generator 103 are accommodated. The pressure vessel 101 is sealed and filled with a coolant 104 such that the electronic equipment 102 and the forced liquid-flow generator 103 are immersed in their entirety.

The electronic equipment 102 is an electronic device such as a computer including semiconductor integrated circuits or at least an electronic circuit such as a processor that is the main source of heat. The electronic equipment 102 may be the overall electronic device. The electronic equipment 102 is fixed by a support mechanism 105 at approximately the center position within the pressure vessel 101. In other words, the electronic equipment 102 is surrounded by the coolant 104, which provides a moderating effect for cosmic rays and neutrons incident from any direction. The support mechanism 105 is configured so as not to impede the flow of the coolant 104 as much as possible.

The forced liquid-flow generator 103 is placed opposite the main surface of the electronic equipment 102 and is fixed by the support mechanism 105. The forced liquid-flow generator 103 has a function of forcedly flowing the coolant 104 within the pressure vessel 101. Preferably, the coolant 104 is forced to flow toward the inner wall of the pressure vessel 101.

More preferably, the forced liquid-flow generator 103 forces the coolant 104 to flow toward the electronic equipment 102, that is, in the direction shown by an arrow a1 in Fig. 1. The forced flow a1 causes the coolant 104 on the electronic equipment 102 to flow in the directions as shown by arrows b1 and b2, improving the efficiency of removing bubbles BB and the efficiency of cooling the electronic equipment 102.

The forced liquid-flow generator 103 can employ any liquid flow generation method, such as a method using a screw or underwater fan. However, if a rotating mechanism is used to generate liquid flow, its angular momentum may be a disturbance to the attitude control of a spacecraft. To avoid this, it is desirable to cancel the angular momentum by operating a pair of rotating fans rotating in opposite directions. In the claimed invention, the forced liquid-flow generator is a contra-rotating fan.

The coolant 104 should be an electrically insulating and thermally conductive liquid, especially containing hydrogen atoms for neutron beam moderation and shielding. For example, a liquid such as CFC substitute or polyester can be used as such coolant 104. In the present exemplary embodiment, when the temperature of the entire pressure vessel 101 is controlled below 60°C, the boiling point of the coolant 104 is about 76°C, for example.

The pressure vessel 101 is also provided with terminals (not shown) for input and output of power and signals to drive the electronic equipment 102 and the forced liquid-flow generator 103.

### 1.2) Cooling and heat dissipation

In Fig. 1, the forced liquid-flow generator 103 is driven, thereby generating the flow of coolant 104 in the direction of arrow a1 (in the vertical direction of Fig. 1). The flow of the coolant 104 is divided on the heat-generating part of the electronic equipment 102 into flows spreading over its surface as typically shown by arrows b1 and b2 (in the directions of a plane perpendicular to the arrow a1). The flows of coolant104 in the directions of the arrows b1 and b2 convey the coolant 104 heated on the electronic equipment 102 and bubbles BB generated by the boiling of the coolant 104 on the electronic equipment 102 to the inner wall of the pressure vessel 101. In this way, the electronic equipment 102 is efficiently cooled. Since the bubbles BB move away from the electronic equipment 102, the dry-out phenomenon can be suppressed.

The heated coolant 104 cools as it moves along the inner wall of the pressure vessel 101, and the bubbles BB condenses back to liquid. The cooled coolant 104 is again forced to flow toward the electronic equipment 102 by the forced liquid-flow generator 103 as shown by the arrow a1. In this way, the cooling process is repeated, allowing the electronic equipment 102 to be cooled by the forced circulation of the coolant 104.

Various heat-dissipation methods can be employed to dissipate heat from the outer surface of the pressure vessel 101. In the case where the outer surface of the pressure vessel 101 is exposed to the outer space, heat can be dissipated directly. In the case where the pressure vessel 101 is radiation-coupled to the external heat sink of the spacecraft, heat can be dissipated depending on its heat flux.

### 2. Generation of forced liquid flow

Hereinafter, as an example of the forced liquid-flow generator 103, a contra-rotating system will be described, which includes a pair of rotating blade units that rotate in opposite directions and generate liquid flow in the same direction. The rotating blade units that generate the liquid flow are referred to as "fans" for convenience.

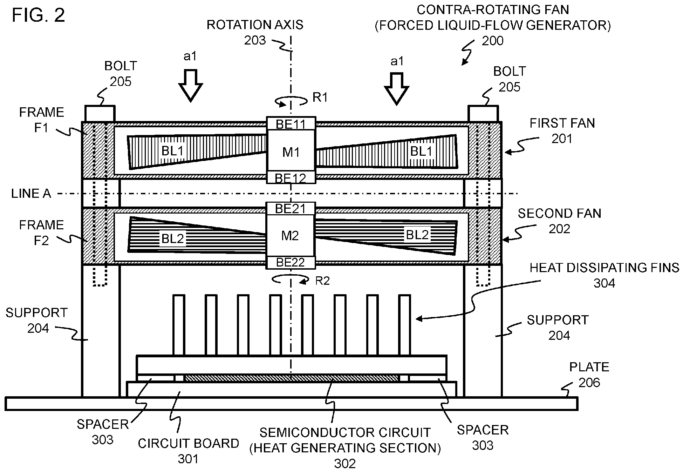

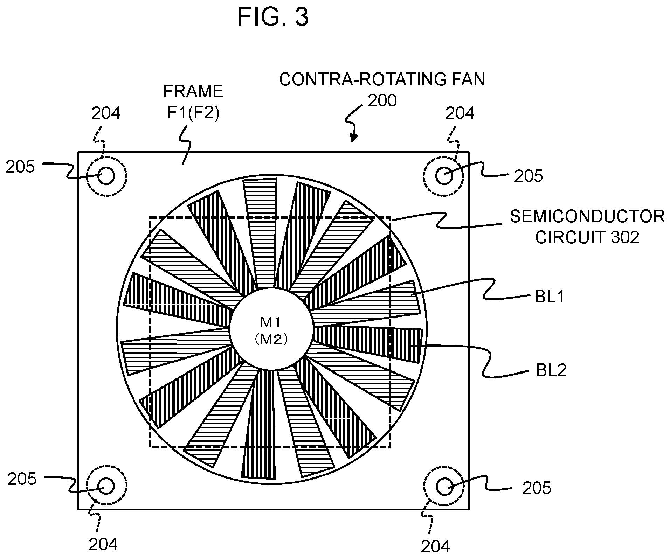

As illustrated in Figs. 2 and 3, the contra-rotating fan 200 is an example of the forced liquid-flow generator 103 employed in the present exemplary embodiment. The contra-rotating fan 200 includes a first fan (first rotating blade unit) 201 and a second fan (second rotating blade unit) 202, which have the same rotation axis 203. The contra-rotating fan 200 has such a structure that the first fan 201 and the second fan 202 are stacked in the direction of the rotation axis 203. The first fan 201 and the second fan 202 have the same structure, shape and mass except that their blades have mirror-image symmetrical orientations or profiles with respect to the line A perpendicular to the rotation axis 203.

The first fan 201 has a predetermined number of blades BL1 fixed to a motor M1. The motor M1 is rotatably supported on a frame F1 by bearings BE11 and BE12. The motor M1 is driven to rotate the blades BL1 in the direction of arrow R1.

Similarly, the second fan 201 has the same number of blades BL2 as the first fan 201. The blades BL2 are fixed to a motor M2. The motor M2 is rotatably supported on a frame F2 by bearings BE21 and BE22. The motor M2 is driven to rotate the blades BL2 in the direction of arrow R2 opposite to that of the arrow R1.

The first fan 201 and the second fan 202 rotate in opposite directions as indicated by R1 and R2, and each fan produces the same liquid flow in the direction of the arrow a1. Since the first fan 201 and the second fan 202 rotate in opposite directions, their angular momentums are canceled out, allowing suppressed disturbances in spacecraft attitude control.

The first fan 201 and the second fan 202 are stacked and fixed to supports 204 on concentric axes which are both on the rotation axis 203. The supports 204 are fixed to a plate 206 such that the bottom surface (coolant outflow surface) of the second fan 202 is placed at a predetermined distance from the plate 206. On the plate 206, a circuit board 301 of the electronic equipment, a semiconductor circuit 302, and heat dissipating fins 303 are stacked in the order from bottom to top. The heat dissipating fins 303 contacts the semiconductor circuit 302 with spacers 303 being placed between the heat dissipating fins 304 and the circuit board 301. The heat dissipating fins 304 and the coolant outflow surface of the second fan 202 are opposed. The distance between the heat dissipating fins 304 and the coolant outflow surface of the second fan 202 is determined taking into account the cooling efficiency of the forced coolant flow.

The flow of coolant generated by the first fan 201 and the second fan 202 passes through the heat dissipating fins 304. Accordingly, the cooling efficiency of the semiconductor circuit 302 is improved and bubbles BB generated on the heat dissipating fins 304 are removed, which can prevent the dry-out phenomenon.

The coolant 104 flows toward the heat spreader fins 304 in the direction shown by the arrow a1, which can obtain a higher cooling effect. However, the coolant flow direction is not limited to the arrow a1. For example, the coolant104 can be made to flow in the opposite direction of arrow a1 (upward in Fig. 2) to remove the coolant and bubbles on the heat dissipating fins 304.

### 3. Example of application

The ruggedizing apparatus 100 as described above can be applied to the ruggedizing of semiconductor circuits included in the electronic equipment mounted in the body of a man-made satellite. For example, a plurality of pieces of electronic equipment 102 are immersed in the coolant104 of the pressure vessel 101, and each electronic equipment 102 is mounted with the forced liquid-flow generator 103, which can achieve both cooling and radiation shielding. Hereinafter, there will be described an example such that the contra-rotating fan 200 shown in Figs. 2 and 3 is applied to the cooling of the semiconductor circuits 302.

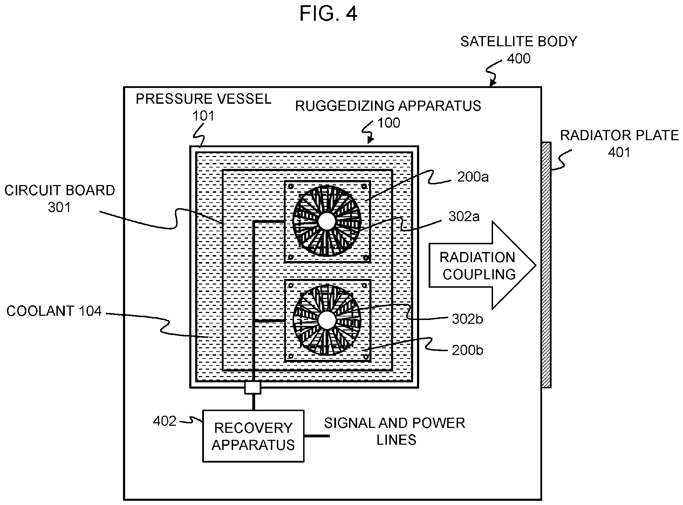

As illustrated in Fig. 4, the ruggedizing apparatus 100 is installed inside a satellite body 400. For heat dissipation, the pressure vessel 101 is radiation-coupled to a radiation plate 40 provided on the outer surface of the satellite body 400. Inside the pressure vessel 101, the circuit board 301 is immersed in the coolant 104 and mounted with semiconductor circuits 302a and 302b, on which contra-rotating fans 200a and 200b are mounted, respectively. The semiconductor circuits 302a and 302b and the contra-rotating fans 200a and 200b are connected to a recovery apparatus 402, through which power is supplied and signal are transmitted and received.

The heat-generating semiconductor circuits 302a and 302b may be separate integrated circuits or a redundant system on the same integrated circuit. For example, if satellite control needs to be performed without interruption, a redundant system may be employed such that the semiconductor circuit 302a is used for a working circuit and the semiconductor circuit 302b is used for a reserved circuit. Normally, the working semiconductor circuit 302a and contra-rotating fan 200a are in operation while the reserved semiconductor circuit 302b and contra-rotating fan 200b are on standby.

Upon the occurrence of a failure or the like in a working system, the recovery apparatus 402 switches circuit operation from the working system to a reserved system. Accordingly, the semiconductor circuit 302b can continue the same control as the semiconductor circuit 302a and the contra-rotating fan 200b rotates to cool the semiconductor circuit 302b. In this way, in case a malfunction occurs in one of the semiconductor circuits, the same operation can continue in the other, enabling non-stop control that maintains the satellite's functions and improving reliability of the satellite.

### 4. Advantageous effects

As mentioned above, according to the exemplary embodiment of the invention, at least the heat-generating semiconductor circuit 302 of electronic equipment is placed within the pressure vessel 101 filled with the coolant 104. Accordingly, the at least the heat-generating semiconductor circuit 302 is immersed in the coolant 104, ensuring that at least the space around the semiconductor circuit 302 is filled with the coolant, thereby obtaining the radiation moderating effect. In addition, the contra-rotating fan 200 forces the coolant on the heat-dissipating fins 3 04 to flow, thereby efficiently cooling the semiconductor circuit 302 and preventing the dry-out phenomenon.

In other words, the ruggedizing apparatus 100 according to the exemplary embodiment can achieve both the radiation shielding effect and the immersion cooling effect by immersing the semiconductor circuit 302, which can become highly heated, in the coolant 104, and forcing the coolant104 to flow in the pressure vessel 101. This allows electronic equipment to operate in the outer space and control the satellite while maintaining its performance.

The present invention is applicable to a ruggedizing apparatus for use in a spacecraft such as a man-made satellite mounted with semiconductor integrated circuits that require cooling.

The present invention is not limited to the exemplary embodiments described above but can be modified in various ways without departing from the scope of the claims.

## Claims

1. A ruggedizing apparatus for electronic equipment (102) in a spacecraft mounted with the electronic equipment (102), comprising:
a pressure vessel (101) that is filled with a coolant (104) and places at least a heat-generating electronic circuit (302) of the electronic equipment (102) within the pressure vessel (101), wherein the heat-generating electronic circuit (302) is immersed in the coolant (104); and
a forced liquid-flow generator (103) placed within the pressure vessel (101), wherein the forced liquid-flow generator (103) causes the coolant (104) on the heat-generating electronic circuit (302) to move away from the heat-generating electronic circuit (302),
**characterized in that**:
the forced liquid-flow generator (103) is a contra-rotating fan causing the coolant (104) to flow in a predetermined direction.

2. The ruggedizing apparatus according to claim 1, wherein the forced liquid-flow generator (103) causes the coolant (104) and bubbles (BB) on the heat-generating electronic circuit (302) to flow toward an inner wall of the pressure vessel (101), wherein the bubbles (BB) are generated by boiling of the coolant (104) on the heat-generating electronic circuit (302).

3. The ruggedizing apparatus according to claim 1 or 2, wherein the forced liquid-flow generator (103) comprises:
a first rotating blade unit (201) that causes the coolant (104) to flow in a predetermined direction; and
a second rotating blade unit (202) that causes the coolant (104) in the predetermined direction,
wherein the first rotating blade unit (201) and the second rotating blade unit (202) rotate in mutually opposite directions on a concentric rotation axis.

4. The ruggedizing apparatus according to any one of claims 1-3, wherein the forced liquid-flow generator (103) causes the coolant (104) to flow toward the heat-generating electronic circuit (302), thereby the coolant (104) and bubbles (BB) on the heat-generating electronic circuit (302) to flow toward an inner wall of the pressure vessel (101), wherein the bubbles (BB) are generated by boiling of the coolant (104) on the heat-generating electronic circuit (302).

5. A ruggedizing method for electronic equipment (102) in a spacecraft mounted with the electronic equipment (102), comprising:
immersing at least a heat-generating electronic circuit (302) of the electronic equipment (102) in a coolant (104) of a pressure vessel (101) that is filled with the coolant (104); and
by a forced liquid-flow generator (103) placed within the pressure vessel (101), forcedly flowing the coolant (104) on the heat-generating electronic circuit (302) to move away from the heat-generating electronic circuit (302),
**characterized in that**:
the forced liquid-flow generator (103) is a contra-rotating fan causing the coolant (104) to flow in a predetermined direction.

6. The ruggedizing method according to claim 5, wherein by the forced liquid-flow generator (103), the coolant (104) and bubbles (BB) on the heat-generating electronic circuit (302) flow toward an inner wall of the pressure vessel (101), wherein the bubbles (BB) are generated by boiling of the coolant (104) on the heat-generating electronic circuit (302).

7. The ruggedizing method according to claim 5 or 6, wherein by the forced liquid-flow generator (103), the coolant (104) flows toward the heat-generating electronic circuit (302), thereby the coolant (104) and bubbles (BB) on the heat-generating electronic circuit (302) flow toward an inner wall of the pressure vessel (101), wherein the bubbles (BB) are generated by boiling of the coolant (104) on the heat-generating electronic circuit (302).

## Patentansprüche

1. Vorrichtung zum Erhöhen der Widerstandsfähigkeit für elektronische Geräte (102) in einem mit den elektronischen Geräten (102) ausgerüsteten Raumfahrzeug, umfassend:
einen Druckbehälter (101), der mit einem Kühlmittel (104) gefüllt ist und wenigstens eine wärmeerzeugende elektronische Schaltung (302) der elektronischen Geräte (102) innerhalb des Druckbehälters (101) platziert, wobei die wärmeerzeugende elektronische Schaltung (302) in das Kühlmittel (104) eingetaucht ist; und
einen Generator für einen erzwungenen Flüssigkeitsstrom (103), der innerhalb des Druckbehälters (101) platziert ist, wobei der Generator für einen erzwungenen Flüssigkeitsstrom (103) veranlasst, dass sich das Kühlmittel (104) auf der wärmeerzeugenden elektronischen Schaltung (302) von der wärmeerzeugenden elektronischen Schaltung (302) wegbewegt,
**dadurch gekennzeichnet, dass**:
der Generator für einen erzwungenen Flüssigkeitsstrom (103) ein gegenläufig rotierender Ventilator ist, der veranlasst, dass das Kühlmittel (104) in einer vorbestimmten Richtung fließt.

2. Vorrichtung zum Erhöhen der Widerstandsfähigkeit nach Anspruch 1, wobei der Generator für einen erzwungenen Flüssigkeitsstrom (103) veranlasst, dass das Kühlmittel (104) und Blasen (BB) auf der wärmeerzeugenden elektronischen Schaltung (302) in Richtung zu einer Innenwand des Druckbehälters (101) fließen, wobei die Blasen (BB) durch Sieden des Kühlmittels (104) auf der wärmeerzeugenden elektronischen Schaltung (302) erzeugt werden.

3. Vorrichtung zum Erhöhen der Widerstandsfähigkeit nach Anspruch 1 oder 2, wobei der Generator für einen erzwungenen Flüssigkeitsstrom (103) folgendes umfasst:
eine erste rotierende Flügeleinheit (201), die veranlasst, dass das Kühlmittel (104) in einer vorbestimmten Richtung fließt; und
eine zweite rotierende Flügeleinheit (202), die das Kühlmittel (104) in der vorbestimmten Richtung veranlasst,
wobei sich die erste rotierende Flügeleinheit (201) und die zweite rotierende Flügeleinheit (202) in wechselseitig entgegengesetzten Richtungen auf einer konzentrischen Rotationsachse drehen.

4. Vorrichtung zum Erhöhen der Widerstandsfähigkeit nach einem der Ansprüche 1 - 3, wobei der Generator für einen erzwungenen Flüssigkeitsstrom (103) veranlasst, dass das Kühlmittel (104) in Richtung zur wärmeerzeugenden elektronischen Schaltung (302) fließt, wodurch das Kühlmittel (104) und die Blasen (BB) auf der wärmeerzeugenden elektronischen Schaltung (302) in Richtung zu einer Innenwand des Druckbehälters (101) fließen, wobei die Blasen (BB) durch Sieden des Kühlmittels (104) auf der wärmeerzeugenden elektronischen Schaltung (302) erzeugt werden.

5. Verfahren zum Erhöhen der Widerstandsfähigkeit für elektronische Geräte (102) in einem mit den elektronischen Geräten (102) ausgerüsteten Raumfahrzeug, umfassend:
Eintauchen wenigstens einer wärmeerzeugenden elektronischen Schaltung (302) der elektronischen Geräte (102) in ein Kühlmittel (104) eines Druckbehälters (101), der mit dem Kühlmittel (104) gefüllt ist; und
durch einen innerhalb des Druckbehälters (101) platzierten Generator für einen erzwungenen Flüssigkeitsstrom (103) erzwungenes Fließen lassen des Kühlmittels (104) auf der wärmeerzeugenden elektronischen Schaltung (302), um sich von der wärmeerzeugenden elektronischen Schaltung (302) wegzubewegen,
**dadurch gekennzeichnet, dass**:
der Generator für einen erzwungenen Flüssigkeitsstrom (103) ein gegenläufiger Ventilator ist, der veranlasst, dass das Kühlmittel (104) in einer vorbestimmten Richtung fließt.

6. Verfahren zum Erhöhen der Widerstandsfähigkeit nach Anspruch 5, wobei durch den Generator für einen erzwungenen Flüssigkeitsstrom (103) das Kühlmittel (104) und Blasen (BB) auf der wärmeerzeugenden elektronischen Schaltung (302) in Richtung zu einer Innenwand des Druckbehälters (101) fließen, wobei die Blasen (BB) durch Sieden des Kühlmittels (104) auf der wärmeerzeugenden elektronischen Schaltung (302) erzeugt werden.

7. Verfahren zum Erhöhen der Widerstandsfähigkeit nach Anspruch 5 oder 6, wobei durch den Generator für einen erzwungenen Flüssigkeitsstrom (103) das Kühlmittel (104) in Richtung zur wärmeerzeugenden elektronischen Schaltung (302) fließt, wodurch das Kühlmittel (104) und die Blasen (BB) auf der wärmeerzeugenden elektronischen Schaltung (302) in Richtung zu einer Innenwand des Druckbehälters (101) fließen, wobei die Blasen (BB) durch Sieden des Kühlmittels (104) auf der wärmeerzeugenden elektronischen Schaltung (302) erzeugt werden.

## Revendications

1. Appareil de renforcement pour équipement électronique (102) dans un engin spatial pourvu de l'équipement électronique (102), comportant :
un récipient sous pression (101) qui est rempli d'un liquide de refroidissement (104) et au moins un circuit électronique générateur de chaleur (302) de l'équipement électronique (102) placé à l'intérieur du récipient sous pression (101), dans lequel le circuit électronique générateur de chaleur (302) est immergé dans le liquide de refroidissement (104) ; et
un générateur d'écoulement forcé de liquide (103) placé à l'intérieur du récipient sous pression (101), dans lequel le générateur d'écoulement forcé de liquide (103) amène le liquide de refroidissement (104) sur le circuit électronique générateur de chaleur (302) à s'éloigner du circuit électronique générateur de chaleur (302),
**caractérisé en ce que** :
le générateur d'écoulement forcé de liquide (103) est un ventilateur à rotation inverse provoquant l'écoulement du liquide de refroidissement (104) dans une direction prédéterminée.

2. Appareil de renforcement selon la revendication 1, dans lequel le générateur d'écoulement forcé de liquide (103) provoque l'écoulement du liquide de refroidissement (104) et de bulles (BB) sur le circuit électronique générateur de chaleur (302) vers une paroi interne du récipient sous pression (101), dans lequel les bulles (BB) sont générées par l'ébullition du liquide de refroidissement (104) sur le circuit électronique générateur de chaleur (302).

3. Appareil de renforcement selon la revendication 1 ou 2, dans lequel le générateur d'écoulement forcé de liquide (103) comporte :
une première unité de pale rotative (201) qui provoque l'écoulement du liquide de refroidissement (104) dans une direction prédéterminée ; et
une seconde unité de pale rotative (202) qui provoque l'écoulement du liquide de refroidissement (104) dans la direction prédéterminée,
dans lequel la première unité de pale rotative (201) et la seconde unité de pale rotative (202) tournent dans des directions opposées l'une à l'autre sur un axe de rotation concentrique.

4. Appareil de renforcement selon l'une quelconque des revendications 1 à 3, dans lequel le générateur d'écoulement forcé de liquide (103) provoque l'écoulement du liquide de refroidissement (104) vers le circuit électronique générateur de chaleur (302), de sorte que le liquide de refroidissement (104) et des bulles (BB) sur le circuit électronique générateur de chaleur (302) s'écoulent vers une paroi interne du récipient sous pression (101), dans lequel les bulles (BB) sont générées par l'ébullition du liquide de refroidissement (104) sur le circuit électronique générateur de chaleur (302).

5. Procédé de renforcement pour équipement électronique (102) dans un engin spatial pourvu de l'équipement électronique (102), comportant :
l'immersion d'au moins un circuit électronique générateur de chaleur (302) de l'équipement électronique (102) dans un liquide de refroidissement (104) d'un récipient sous pression (101) qui est rempli du liquide de refroidissement (104) ; et
par un générateur d'écoulement forcé de liquide (103) placé à l'intérieur du récipient sous pression (101), l'écoulement forcé du liquide de refroidissement (104) sur le circuit électronique générateur de chaleur (302) pour l'éloigner du circuit électronique générateur de chaleur (302),
**caractérisé en ce que** :
le générateur d'écoulement forcé de liquide (103) est un ventilateur à rotation inverse provoquant l'écoulement du liquide de refroidissement (104) dans une direction prédéterminée.

6. Procédé de renforcement selon la revendication 5, dans lequel, par le générateur d'écoulement forcé de liquide (103), le liquide de refroidissement (104) et des bulles (BB) sur le circuit électronique générateur de chaleur (302) s'écoulent vers une paroi interne du récipient sous pression (101), dans lequel les bulles (BB) sont générées par l'ébullition du liquide de refroidissement (104) sur le circuit électronique générateur de chaleur (302).

7. Procédé de renforcement selon la revendication 5 ou 6, dans lequel, par le générateur d'écoulement forcé de liquide (103), le liquide de refroidissement (104) s'écoule vers le circuit électronique générateur de chaleur (302), ainsi le liquide de refroidissement (104) et les bulles (BB) sur le circuit électronique générateur de chaleur (302) s'écoulent vers une paroi interne du récipient sous pression (101), dans lequel les bulles (BB) sont générées par l'ébullition du liquide de refroidissement (104) sur le circuit électronique générateur de chaleur (302).
